# EUROPEAN PATENT SPECIFICATION

(11) **EP 2 380 212 B1**
(45) Date of publication and mention of the grant of the patent: **20.03.2013**
(21) Application number: 09799170.7
(22) Date of filing: 17.12.2009
(51) Int. Cl.: H01L 31/052, H01L 31/055, H01L 31/042

(54) **A photovoltaic system for an electronic appliance**
Photovoltaiksystem für eine elektronische Vorrichtung
Système photovoltaïque pour appareil électronique

(30) Priority: 19.12.2008 EP 08172367; 16.09.2009 EP 09170413
(43) Date of publication of application: 26.10.2011
(73) Proprietor: Koninklijke Philips Electronics N.V., 5621 BA Eindhoven (NL)
(72) Inventor: LIFKA, Herbert, NL-5656 AE Eindhoven (NL); PASVEER, Willem, F., NL-5656 AE Eindhoven (NL)
(74) Representative: Coops, Peter
(86) International application number: PCT/IB2009/055820
(87) International publication number: WO 2010/070607

(56) References cited:
- DE-A1- 19 952 814
- FR-A- 2 904 729
- JP-A- 7 131 051
- JP-A- 55 020 462
- JP-A- 59 035 483
- JP-A- 2000 111 670
- JP-A- 2001 305 249
- JP-B1- 3 773 944
- US-A1- 2006 037 640
- US-A1- 2008 171 157
- US-A1- 2008 198 469

## Description

### FIELD OF THE INVENTION

The present invention relates to a photovoltaic system for an electronic appliance and to an electronic appliance comprising such a photovoltaic system.

### BACKGROUND OF THE INVENTION

In the last years, different types of photovoltaic systems have been developed for outdoor applications such as on house roof tops, which lead to a large planar construction, where the radiation intensity levels are sufficiently high.

For example, Japanese Patent Application JP07-131051 discloses a photovoltaic system aimed at optimizing solar panel efficiency. To this end the prior art system uses a stack comprising multiple panels made of a resin containing a dye for concentrating light of a specified wavelength. The light of the specified wavelength is then guided to a solar cell placed adjacent to an open end of the respective resin board. However, solar energy use for indoor appliances remains very difficult due to the relatively low indoor radiation intensity levels compared to the outdoor radiation intensity levels (indoor levels are approximately 1-10% of the outdoor levels). In order to compensate for this difference in intensity levels the surface area of the photovoltaic system may be enlarged. However this is very costly and as a result such photovoltaic systems do not find much application indoors. JP2001305249 discloses a wrist watch powered by a photovoltaic concentrator comprising a ring-like solar cell.

### BRIEF DESCRIPTION OF THE INVENTION

The object of this invention is to ameliorate the above problem, by providing a photovoltaic system according to claim 1 which may be used under low radiation conditions, for example in order to provide power for indoor electronic appliances.

According to one aspect the present invention relates to a photovoltaic system for an electronic appliance, comprising: an energy concentrator having an outer layer and an inner layer, wherein the outer layer is adapted to gather incoming electromagnetic radiation into the energy concentrator and wherein the inner layer is adapted for reflecting electromagnetic radiation such that the electromagnetic radiation becomes concentrated within the energy concentrator, a solar cell optically coupled to the energy concentrator, such that light concentrated in the energy concentrator is directed to the solar cell, and wherein the solar cell is adapted to act as a power source for the electronic appliance, wherein the outer layer of the energy concentrator forms part of an outer surface of the electronic appliance and the inner layer of the energy concentrator is formed around a cavity for hosting electronic or mechanical components of the electronic appliance and the energy concentrator is configured to reflect light through the energy concentrator around at least part of the cavity.

Accordingly, a photovoltaic system is provided that requires only low electromagnetic radiation conditions to drive appliances, such as e.g. in indoor applications. By using the energy concentrator as the "skin" of part of the appliance or for the entirety of the appliance parts or even the entire exterior surface of the device can be used to collect energy.

Energy concentrators are preferably used to improve on the efficiency of power generation for solar cells. Typically the light exposed surface area of the energy concentrator is larger than the light exposed surface area of the solar cell(s). As a result the energy concentrator can capture light and provide it in a more concentrated form to the solar cells, thereby enabling a reduction of the number of solar cells or active area of solar cells.

In an embodiment of the invention the electromagnetic radiation reflected by the inner layer corresponds with the incoming electromagnetic radiation.

In another embodiment the solar concentrator is a so-called luminescent solar concentrator (LSC). A luminescent solar concentrator generally comprises a collector being designed as a flat and optically transparent or semi transparent sheet. This sheet often is formed of a material such as glass, polymer, or the like. The collector comprises or is coated with a luminescent substrate which absorbs the incident sunlight and emits light at longer wavelengths.

As a result electromagnetic radiation reflected by the inner layer corresponds with electromagnetic radiation generated by means of the energy of the incoming electromagnetic radiation, but need not have the same wavelength.

The electromagnetic radiation reflected by the inner layer in both embodiments discussed directly above results from the energy of the incoming electromagnetic radiation.

It is noted that in particular when more than 50% of the exterior surface of the device is being used as energy concentrator, typically at least some parts of the energy concentrator will be exposed to ambient light, even when the device is placed with part of the energy concentrator positioned face down.

It is further noted that in particular when more than 75% of the exterior surface of the device is being used as energy concentrator the probability that ambient light may be used to provide power for the appliance is once more substantially increased; as in this scenario it is highly likely that ambient light is incident on the exterior surface of the device.

By shaping the energy concentrator in such a manner that light is reflected along at least a path around the cavity, light incident from a wide range of angles can be concentrated and can be directed towards one or more solar cells. Even in situations where the photovoltaic system is positioned such that the solar cell is placed face down on an opaque surface, or where the solar cell is positioned facing away from any light sources present, exposed areas of the energy concentrator may still be able to concentrate a substantial amount of light from the light source and deliver it to the solar cell.

Moreover as the energy concentrator captures light and directs that light around the cavity the specific location of the solar cell on the appliance has become less critical. Through the use of the energy concentrator the freedom to position the solar cell on the appliance has increased, as has the freedom to position/orient the electrical appliance with respect to the position/orientation of any sources of radiation. The above holds in particular when the outer layer represents a significant part of the exterior surface of an appliance.

In one embodiment the energy concentrator spans more than 180 degrees of the exterior surface of the appliance on a cross section through the cavity and the energy concentrator. As a result the probability that the energy concentrator may be able to concentrate ambient light better on account of the greater directional exposure compared to planar energy concentrators.

In one embodiment the energy concentrator spans 360 degrees or approximately 360 degrees of the exterior surface of the appliance on a cross section through the cavity and the energy concentrator. As a result the probability that the energy concentrator may be able to concentrate ambient light is further enhanced.

In an embodiment wherein the energy concentrator spans 360 degrees of the exterior surface of the appliance, the energy concentrator is arranged to reflect light completely around the cavity; i.e. in the cross section the energy concentrator is arranged such that the reflected light can circle the cavity along 360 degrees. As a result thereof the potential to gather light from a variety of incoming directions is further increased. Moreover the probability that the reflected light eventually reaches a solar cell is also increased.

It will be clear to the skilled person that the improvements provided by the present invention can be used to make a trade-off between increased efficiency, increased design freedom and reduction of cost.

For example as incident radiation is concentrated by the energy concentrator and thus increases efficiency, parts of the energy concentrator may be sacrificed for other purposes such as e.g. signage, colors, buttons, etc.

Electromagnetic radiation as discussed herein can include all wavelengths, but for a typical electric application the electromagnetic radiation is within the visible range (400-700nm), or even within the ultraviolet or infrared range.

In one embodiment the solar cell or plurality of solar cells are positioned within the cavity. By placement of the solar cell(s) in the cavity, the energy concentrator provides physical protection for the solar cell(s). Optionally the solar cell(s) may be optically coupled to the energy concentrator by means of optical fibers. This enables embodiments wherein the solar cell(s) are grouped together and placed on a single surface to facilitate manufacturing.

Preferably, the solar cells are attached to the inner layer of the energy concentrator by means of optical conductive glue, or other optical coupling. By attachment of the solar cells to the inner layer, there is no need for feedthroughs through the energy concentrator to provide power to electronic or mechanical components inside the cavity formed by the energy concentrator.

In one embodiment, the physical shape of the energy concentrator is such that it allows light to reflect around the cavity. As it is the physical shape of the energy concentrator which causes the light to reflect around the cavity no further optical means are required.

In one embodiment the energy concentrator is or comprises a hollow, substantially cylindrical shape and the photovoltaic system comprises a plurality of solar cells that are distributed along a helical path along the cavity surface of the energy concentrator. Photons passing through the outer layer into the energy concentrator may have a wide range of initial directions, resulting in an equally wide range of paths through the energy concentrator. By distributing the solar cells, or optical couplings for the solar cells, in a helical path along the inner layer, the number of reflections of the photons can be reduced and thus efficiency can be increased.

Although the above clearly holds for a purely cylindrical shape a similar line of reasoning also holds for cylindrical shapes that have flattened sides or cubical shapes with rounded edges.

In another embodiment the energy concentrator is or comprises a hollow, substantially cylindrical shape and the photovoltaic system comprises a plurality of solar cells that are distributed along a helical path along the outer layer of the cylindrical shape of the energy concentrator.

It will be clear to the skilled person that for the energy concentrator to function optimally the energy concentrator in the above embodiments needs to reflect light back into the energy concentrator. As a result the edges of the hollow cylindrical shape described above are preferably provided with a reflective coating, such as a metal coating, so as to minimize energy leakage out of the concentrator in locations where no solar cell is provided.

In one embodiment, the inner layer is a mirror layer.

In one embodiment, the outer layer is a plastic, or a glass, or a wavelength selective mirror for gathering some of the wavelengths of the incoming electromagnetic radiation and where the wavelength selective mirror also acts as a reflector for the incoming electromagnetic radiation.

In one embodiment, the wavelength selective mirror is combined with an electromagnetic radiation conversion layer. In an alternative embodiment the energy collector comprises or is coated with a luminescent substrate. By means of these embodiments it is possible to gather/harvest only certain wavelengths that are likely to contain most energy or alternatively to gather/harvest energy of wavelengths that matched to environmental conditions.

In one embodiment, at least one feedthrough is made through the energy concentrator for hosting at least one control buttons that is adapted to be operatively connected to the electronics of the appliance for controlling the appliance. By doing so, a space is provided for one or more control buttons, e.g. if the energy concentrator has a shape of a remote control a space is provided for the various control buttons for the remote control.

In one embodiment, the wall of the feedthrough is metalized. In that way, the electromagnetic radiation will be reflected towards the concentrator and will not escape through the feedthrough.

In one embodiment, the photovoltaic system is coupled to a sensor. Accordingly, the photovoltaic system may e.g. be suited for powering solutions for wireless sensors for building control e.g. for operating switching lamps on/off or adjusting the brightness for energy saving. This coupling may be wireless or a wired coupling.

In one embodiment, the photovoltaic system further comprises a power storage means coupled to the solar cells, where the solar cells act as a power source to the electric appliance via the power storage means. This may as an example include a rechargeable battery or a super-capacitor electrically coupled to the solar cells, where the solar cells act as a power source to the electric appliance via the battery or a super-capacitor.

In one embodiment, the photovoltaic system further comprises a parent energy concentrator comprising an optical coupling means which is adapted to be optically connected to the electronic appliances such that the parent energy concentrator acts as an additional power source for the power storage means when optically connected to the electronic appliances. As an example, a telephone may be equipped with a solar concentrator skin and also the base-station (i.e. the parent energy concentrator) may be equipped with such solar concentrator skin. The concentrator skin of the base-station can be significantly larger and/or may be positioned better with respect to incident sunlight. Thus, when the phone is put on the base station it becomes optically connected to the base station and thus the re-charging of the power storage means (e.g. battery) becomes much faster due to the enlarged area of the energy concentrator. This parent energy concentrator may also act as a shelf in the bathroom for one or more electrical toothbrushes, such that when the toothbrushes are placed in or on this "shelf", they become optically connected to the parent energy concentrator and as such will be charged faster.

In one embodiment, the energy concentrator is formed by at least a first and a second energy concentrator parts which are optically connected together. Accordingly, this may include two or more pieces of energy concentrators, which after e.g. an injection molding process need to be connected together. The coupling can be e.g. via a thin optically conducting glue and the like. Also mechanical coupling with e.g. screws or clamping can be used to couple the parts.

According to still another aspect, the present invention relates to a (wireless) sensor or an electronic appliance comprising said photovoltaic system.

In one embodiment, the electronic appliances further comprise a rechargeable battery electrically coupled to the solar cells. Accordingly, the battery may be recharged by the photovoltaic system, or the battery may be adapted to act as a power source when the radiation intensity is negligible (e.g. in dark).

The aspects of the present invention may each be combined with any of the other aspects. These and other aspects of the invention will be apparent from and elucidated with reference to the embodiments described hereinafter.

### BRIEF DESCRIPTION OF THE DRAWINGS

Embodiments of the invention will be described, by way of example only, with reference to the drawings, in which
Fig. 1 shows a photovoltaic system according to the present invention for electronic appliance,
Fig. 2 illustrates graphically the functioning of an energy concentrator used in the photovoltaic system,
Fig. 3 shows an example of an indoor electric appliance which as shown is an electric toothbrush,
Fig. 4 shows a cross section of the energy concentrator in Fig. 3, and
Fig. 5 shows another example of an indoor electric appliance which in this case is a remote control.

### DESCRIPTION OF EMBODIMENTS

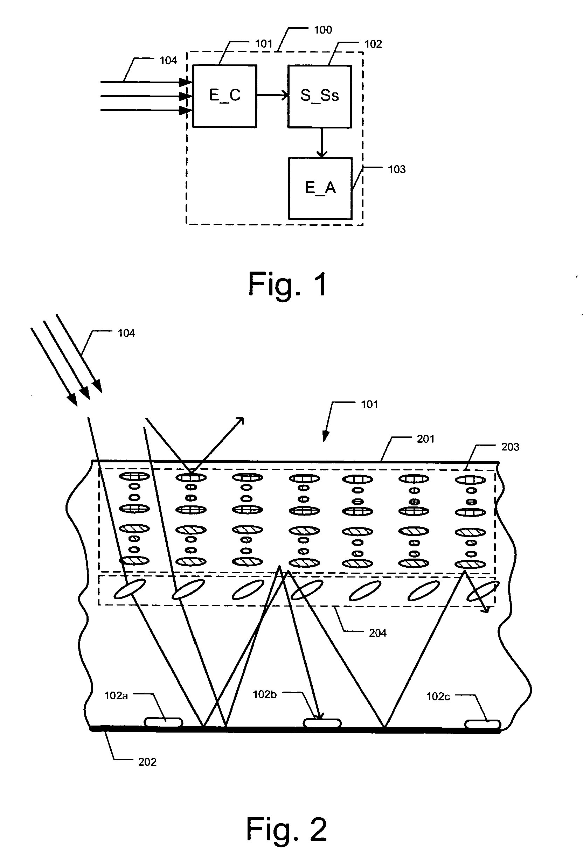

Figure 1 shows a photovoltaic system 100 according to the present invention for electronic appliance (E_A) 103, where the system comprises an energy concentrator (E_C) 101 and a number of solar cells (S_Ss) 102 which act as a power source for the electrical appliance (E_A) 103. The electronic appliance is in one embodiment an indoor electric appliance such as a toothbrush, a remote control, a computer mouse, a sensor system and the like. The electronic appliance may however just as well be an outdoor appliance.

The solar cells (S_Ss) 102 may be connected internally via a metal wiring by e.g. connecting them in series or in parallel or combination thereof. The connection between the solar cells and the electrical appliance (E_A) 103 is in one embodiment performed by connecting them to a power storage means via a power management unit (for e.g. preventing overcharging). The power storage means may then as an example be connected to the driving motor of the electronic appliance (e.g. in case the electric appliance is an electric toothbrush) for driving the electric appliance, or to a (micro) controller for powering a (micro) controller that drives e.g. a wireless interface for RF remote control.

As depicted graphically in Figure 2, the energy concentrator (E_C) 101 comprises an outer layer 201 and an inner layer 202. The outer layer gathers an incoming electromagnetic radiation 104 into the energy concentrator (E_C) 101 and the inner layer acts as a reflector for the incoming electromagnetic radiation 104 such that the incoming electromagnetic radiation becomes concentrated within the energy concentrator (E_C) 101. In this embodiment, the solar cells (S_Ss) 102a-102c are embedded in the inner layer and act as a power source for the electronic appliance (E_A) 103. However, they may just as well be attached to the inner of the outer layer 201, or to both the inner and the outer layers 201, 202.

Alternatively light-guides or optical couplings can be provided to couple the inner and/or outer layer with respective solar cells. For example an optical fiber may provide an optical coupling between the inner/outer layer and a respective solar cell. In this manner the solar cells may be clustered within the cavity 305.

Any types of suitable solar cells may be applied, depending on the application. As an example, the solar cells (S_Ss) 102 are understood to include silicon mono-crystalline cells. The diameter of the solar cells can be various, e.g. within the millimeter range millimeters (e.g. 6x6mm) and the thickness may be within the micro range, e.g. around 250µm. However, this along with the number of solar cells needed depends on the type of the electronic appliance, e.g. the amount of power that is required to drive the electric appliance.

The electromagnetic radiation can include all wavelengths, but for a typical electric appliance that will be discussed in more details later, the electromagnetic radiation is typically within the visible range (400-800nm). However, for some applications the electromagnetic radiation may also be in the ultraviolet or infrared range.

In one embodiment, the inner layer 202 is a mirror layer, e.g. metal or metal coated layer, and the outer layer 201 is the outer surface of the energy concentrator, which can be made of plastic or glass. In the embodiment shown in Fig. 2 the outer layer is a wavelength selective mirror 203 that gathers some of the wavelengths of the incoming electromagnetic radiation, e.g. those containing most energy, and where the wavelength selective mirror also acts as a reflector for the incoming electromagnetic radiation. The wavelength selective mirror may further be combined with electromagnetic radiation converting layer 204. Accordingly, by combining wavelength selective mirror 203 and electromagnetic radiation conversion layer 204 together, it is e.g. possible to reflect a red light and convert green and blue to red. Thus, the red from the sun will be reflected, but the converted other colors will be locked in the energy concentrator and reflected towards the solar cells. In this manner, it is possible to concentrate certain colors that are likely to contain most energy.

The physical shape of the energy concentrator (E_C) 101 forms part of the outer layer of the electronic appliance (E_A) 103. The distribution of the solar cells is preferably adapted to this physical shape such that the reflections of the light within the energy concentrator are reduced. This will be explained in more detail here below.

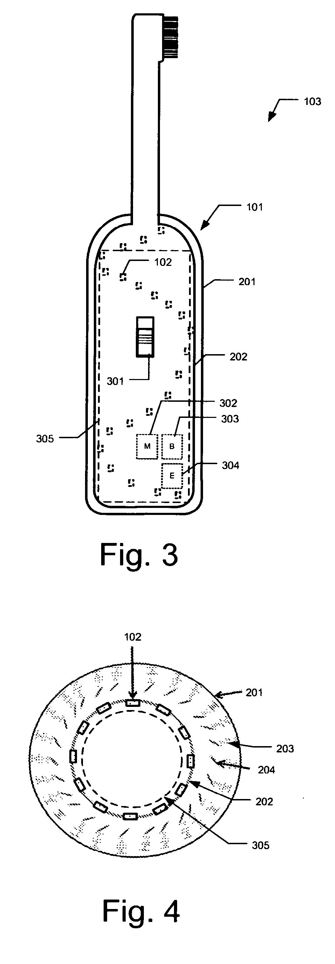

Figure 3 shows an example of an indoor electric appliance which as shown is an electric toothbrush and Figure 4 shows a cross section of the energy concentrator (E_C) 101 for the electric toothbrush. As shown here, the physical shape of the energy concentrator (E_C) 101 is a hollow cylinder, and the solar cells 102 are attached to the inner surface 202 and are distributed in such a way that they form a helix. Photons incident on the outer layer can be incident at any angle, as there is no fixed relation between the position and/or orientation of sources of radiation and the position and/or orientation of the energy concentrator. As a result the initial direction of light entering the energy concentrator can be modeled as random. The subsequent path of the light within the energy concentrator is determined by the reflecting layers. By distributing the solar cells along a helical path on the inner layer the number of reflections of the photons until they will be absorbed by the solar cells 102 may be reduced and thus energy efficiency may be increased. It should be noted that such a helical arrangement is suitable for this particular geometry. However, for different types of geometries, a different distribution of the solar cells may be in order. Accordingly, the distribution may include straight lines, circles, V or U-shape etc., all depending on the physical shape of the of the energy concentrator.

Moreover depending on the average number of reflections and the energy losses incurred the number of solar cells may be further increased by adding one or more further helixes spaced equidistant to one another, or alternatively by providing a further helix that is oriented in the opposite direction.

As depicted in Figure 4, the inner and outer layer of the energy concentrator (E_C) 101, in the absence of the solar cells, represent an endless path for light entering the energy concentrator. Accordingly, incident light need not be focused onto a particular focal point as the photons will be reflected back and forth around the path until they hit one of the solar cells 102. As shown in Fig. 4, the inner layer forms a cavity 305 which can be used for hosting at least some of the electronic components for the electronic appliance or for hosting mechanical moving component parts associated to the electronic appliance such as a camera lens or a protrusion for a razor. As shown here, the electronic components may include the driving motor (M) 302 for the toothbrush, a rechargeable battery (B) 303 or a super-capacitor and other electrical components (E) 304. The rechargeable battery is coupled to the driving motor (M) 302 and to the solar cells 102, which apply the charging energy to the battery (or the super-capacitor). Accordingly, in this embodiment instead of acting directly as a power source for the driving motor (M) 302, the energy supplied by the solar cells is used to charge the battery (B) 303.

As shown here, the energy concentrator (E_C) 101 is provided with a feedthrough 301 through the energy concentrator for hosting a control button, in this case an on/off button for the toothbrush. This feedthrough is preferably metalized so as to prevent photons from escaping out of the energy concentrator.

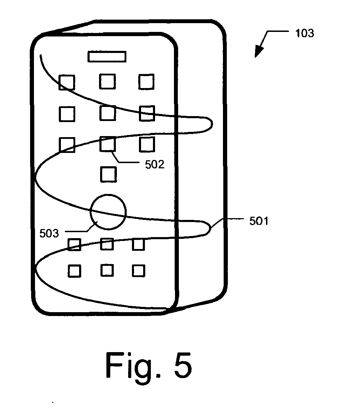

Figure 5 shows another example of an indoor electric appliance 103 which in this case is a remote control. The spiral line 501 indicates a preferred arrangement of the solar cells for this physical shape of the energy concentrator (E_C) 101. As depicted here, the feedthroughs 502, 503 serve to host the control buttons for the remote control. As mentioned previously, these feedthroughs are preferably mirror coated to prevent that the photons within the energy concentrator can escape through the exposed surface of the energy concentrator (E_C) 101 where these control buttons are located.

The photovoltaic system may also be wired/wirelessly coupled to another electronic appliance, e.g. when the photovoltaic system is used to power one or more sensors in a sensor network.

The photovoltaic system may also comprise a parent energy concentrator, wherein the energy concentrator of the photovoltaic system may be coupled to the parent energy concentrator, where e.g. part of the shelf of a mirror in the bathroom is used as an energy concentrator and/or photovoltaic system for hosting multiple toothbrushes. Such wired/wireless coupling may allow the wireless exchange of electrical power.

In case of a wireless transfer of energy, the toothbrush is put on the parent energy concentrator and thus becomes optically connected and as such charges faster due to the enlarged surface area for the collection of radiation.

Another example could be a telephone equipped with a photovoltaic system according to the present invention as its "skin" and the base-station of the telephone having an energy concentrator. Accordingly, when the telephone is put on the base-station both energy concentrators are optically connected, or coupled, and as such battery charging speeds can be improved as a result of the enlarged surface area of the energy concentrator.

Although not shown here, the energy concentrator (E_C) 101 may be formed by at least a first and a second energy concentrator parts which are optically connected together. As an example, the cylindrical shaped energy concentrator in Figure 3 may be formed by two energy concentrator parts, i.e. two half cylinders (or more) which are optically connected together. The same applies for the remote control shown in Figure 5, where one energy concentrator part is the front side of the remote control and the other energy concentrator part is the back side. These may then later on, e.g. during fabrication, be glued together using e.g. optically conducting glue. Also mechanical connection methods such as screwing and/or clamping can be used to connect the parts.

Certain specific details of the disclosed embodiment are set forth for purposes of explanation rather than limitation, so as to provide a clear and thorough understanding of the present invention. However, it should be understood by those skilled in this art, that the present invention might be practiced in other embodiments that do not conform exactly to the details set forth herein, without departing significantly from the scope of this disclosure. Further, in this context, and for the purposes of brevity and clarity, detailed descriptions of well-known apparatuses, circuits and methodologies have been omitted so as to avoid unnecessary detail and possible confusion.

The inclusion of reference signs in the claims is only for clarity reasons and should not be construed as limiting the scope of the claims.

## Claims

1. A photovoltaic system (100) for an electronic appliance (103), comprising:
- an energy concentrator (101) having an outer layer (201) and an inner layer (202), wherein the outer layer (201) is adapted to gather incoming electromagnetic radiation into the energy concentrator (101) and wherein the inner layer (202) is adapted for reflecting electromagnetic radiation such that the electromagnetic radiation becomes concentrated within the energy concentrator (101),
- a solar cell (102) optically coupled to the energy concentrator (101), such that light concentrated in the energy concentrator is directed to the solar cell, and wherein the solar cell is adapted to act as a power source for the electronic appliance (103),
**characterized in that**
- the outer layer (201) of the energy concentrator (101) has a substantially cylindrical shape that forms part of an outer surface of the electronic appliance (103),
- the inner layer (202) of the energy concentrator (101) forms a cavity (305) inside the substantially cylindrical shape for hosting electronic or mechanical components of the electronic appliance (103), and
- the energy concentrator is configured to reflect light through the energy concentrator (101) around at least a part of the cavity (305).

2. A photovoltaic system according to claim 1, wherein the solar cell (102) is positioned within the cavity (305).

3. A photovoltaic system according to claim 1, wherein the physical shape of the energy concentrator (101) is such that it allows light to reflect along a path around the cavity (305).

4. A photovoltaic system according to claim 1, wherein the cavity (305) comprises a hollow, substantially cylindrical shape and the photovoltaic system comprises a plurality of solar cells (102a-102c) distributed along a helical path.

5. A photovoltaic system according to claim 4, wherein the solar cells (102a-102c) are distributed along a helical path along the cavity surface of the energy concentrator (101).

6. A photovoltaic system according to claim 4, wherein the solar cells (102a-102c) are distributed along a helical path along the outer layer of the energy concentrator (101).

7. A photovoltaic system according to claim 1, wherein the energy concentrator (101) comprises at least one feedthrough (301, 501-503) for hosting at least one control buttons adapted to be operatively connected to the electronics of the appliances (103) for controlling the appliances.

8. A photovoltaic system according to claim 7, wherein the feedthrough is metalized so as to reflect light incident from the energy concentrator back into the energy concentrator (101).

9. A photovoltaic system according to claim 1, further comprising a power storage means (303) coupled to the solar cells (102), where the solar cells (102) act as a power source to the electric appliances via the power storage means (303).

10. A photovoltaic system according to claim 9, further comprising a parent energy concentrator comprising an optical coupling means which is adapted to be optically connected to the electronic appliance such that the parent energy concentrator acts as an additional power source for the power storage means when optically connected to the electronic appliance.

11. A photovoltaic system according to claim 1, wherein the energy concentrator (101) is formed by at least a first and a second energy concentrator parts which are optically connected together.

12. A photovoltaic system according to anyone of claims 1-11, wherein the outer layer (201) is a wavelength selective mirror (203) for gathering some of the wavelengths of the incoming electromagnetic radiation and where the wavelength selective mirror also acts as a reflector for the incoming electromagnetic radiation.

13. A sensor comprising a photovoltaic system (100) as claimed in anyone of claims 1-12.

14. An electronic appliance (103) comprising a photovoltaic system (100) as claimed in anyone of claims 1-12.

## Patentansprüche

1. Photovoltaiksystem (100) für ein elektronisches Gerät (103), mit:
- einem Energiekonzentrator (101) mit einer Außenschicht (201) und einer Innenschicht (202), wobei die Außenschicht (201) so ausgebildet ist, dass sie ankommende elektromagnetische Strahlung auffängt und dem Energiekonzentrator (101) zuführt, und wobei die Innenschicht (202) so ausgebildet ist, dass sie elektromagnetische Strahlung so reflektiert, dass die elektromagnetische Strahlung innerhalb des Energiekonzentrators (101) konzentriert wird,
- einer Solarzelle (102), die mit dem Energiekonzentrator (101) so optisch gekoppelt ist, dass in dem Energiekonzentrator konzentriertes Licht auf die Solarzelle gelenkt wird, und wobei die Solarzelle so ausgebildet ist, dass sie als eine Energiequelle für das elektronische Gerät (103) arbeitet,
**dadurch gekennzeichnet, dass**
- die Außenschicht (201) des Energiekonzentrators (101) eine im Wesentlichen zylindrische Form aufweist, die einen Teil einer Außenfläche des elektronischen Geräts (103) bildet,
- die Innenschicht (202) des Energiekonzentrators (101) eine Kavität (305) innerhalb der im Wesentlichen zylindrischen Form bildet, um elektronische oder mechanische Komponenten des elektronischen Geräts (103) aufzunehmen; und
- der Energiekonzentrator so konfiguriert ist, dass er Licht durch den Energiekonzentrator (101) um zumindest einen Teil der Kavität (305) reflektiert.

2. Photovoltaiksystem nach Anspruch 1, wobei die Solarzelle (102) innerhalb der Kavität (305) positioniert ist.

3. Photovoltaiksystem nach Anspruch 1, wobei die physikalische Form des Energiekonzentrators (101) so vorgesehen ist, dass Licht entlang einem Weg um die Kavität (305) reflektieren kann.

4. Photovoltaiksystem nach Anspruch 1, wobei die Kavität (305) eine hohle, im Wesentlichen zylindrische Form aufweist und das Photovoltaiksystem mehrere, entlang einem spiralförmigen Weg verteilte Solarzellen (102a-102c) umfasst.

5. Photovoltaiksystem nach Anspruch 4, wobei die Solarzellen (102a-102c) entlang einem spiralförmigen Weg entlang der Kavitätsoberfläche des Energiekonzentrators (101) verteilt sind.

6. Photovoltaiksystem nach Anspruch 4, wobei die Solarzellen (102a-102c) entlang einem spiralförmigen Weg entlang der Außenschicht des Energiekonzentrators (101) verteilt sind.

7. Photovoltaiksystem nach Anspruch 1, wobei der Energiekonzentrator (101) mindestens eine Durchführung (301, 501-503) umfasst, um mindestens einen Bedienungsknopf unterzubringen, der so ausgeführt ist, dass er mit der Elektronik der Geräte (103) zur Steuerung derselben betriebsbereit verbunden ist.

8. Photovoltaiksystem nach Anspruch 7, wobei die Durchführung metallbeschichtet ist, um von dem Energiekonzentrator auffallendes Licht zurück in den Energiekonzentrator (101) zu reflektieren.

9. Photovoltaiksystem nach Anspruch 1, das weiterhin ein mit den Solarzellen (102) gekoppeltes Leistungsspeichermittel (303) umfasst, wobei die Solarzellen (102) über das Leistungsspeichermittel (303) als eine Energiequelle für die elektrischen Geräte arbeiten.

10. Photovoltaiksystem nach Anspruch 9, das weiterhin einen Haupt-Energiekonzentrator mit einem optischen Kopplungsmittel umfasst, das so ausgeführt ist, dass es mit dem elektronischen Gerät so optisch verbunden wird, dass der Haupt-Energiekonzentrator bei optischer Verbindung mit dem elektronischen Gerät als eine zusätzliche Energiequelle für das Leistungsspeichermittel arbeitet.

11. Photovoltaiksystem nach Anspruch 1, wobei der Energiekonzentrator (101) durch zumindest einen ersten und einen zweiten Energiekonzentratorteil, die miteinander optisch verbunden sind, gebildet wird.

12. Photovoltaiksystem nach einem der Ansprüche 1-11, wobei die Außenschicht (201) ein wellenlängenselektiver Spiegel (203) ist, um einige der Wellenlängen der ankommenden elektromagnetischen Strahlung aufzufangen, und wobei der wellenlängenselektive Spiegel ebenfalls als ein Reflektor für die ankommende elektromagnetische Strahlung arbeitet.

13. Sensor mit einem Photovoltaiksystem (100) nach einem der Ansprüche 1-12.

14. Elektronisches Gerät (103) mit einem Photovoltaiksystem (100) nach einem der Ansprüche 1-12.

## Revendications

1. Système photovoltaïque (100) pour appareil électronique (103), comprenant :
- un concentrateur d'énergie (101) comportant une couche externe (201) et une couche interne (202), dans lequel la couche externe (201) est conçue pour recueillir un rayonnement électromagnétique entrant dans le concentrateur d'énergie (101) et dans lequel la couche interne (202) est conçue pour réfléchir un rayonnement électromagnétique de façon que le rayonnement électromagnétique se concentre dans le concentrateur d'énergie (101),
- une cellule solaire (102) couplée optiquement au concentrateur d'énergie (101), de façon qu'une lumière concentrée dans le concentrateur d'énergie soit dirigée vers la cellule solaire, et dans lequel la cellule solaire est conçue pour jouer le rôle de source d'énergie pour l'appareil électronique (103),
**caractérisé en ce que**
- la couche externe (201) du concentrateur d'énergie (101) possède une forme sensiblement cylindrique formant une partie d'une surface externe de l'appareil électronique (103),
- la couche interne (202) du concentrateur d'énergie (101) forme une cavité (305) à l'intérieur de la forme sensiblement cylindrique pour loger des composants électroniques ou mécaniques de l'appareil électronique (103), et
- le concentrateur d'énergie est conçu pour réfléchir une lumière à travers le concentrateur d'énergie (101) autour d'au moins une partie de la cavité (305).

2. Système photovoltaïque selon la revendication 1, dans lequel la cellule solaire (102) est positionnée au sein de la cavité (305).

3. Système photovoltaïque selon la revendication 1, dans lequel la forme physique du concentrateur d'énergie (101) est telle qu'elle permet à une lumière de se réfléchir le long d'un trajet autour de la cavité (305).

4. Système photovoltaïque selon la revendication 1, dans lequel la cavité (305) comprend une forme creuse sensiblement cylindrique et le système photovoltaïque comprend une pluralité de cellules solaires (102a-102c) réparties le long d'un trajet hélicoïdal.

5. Système photovoltaïque selon la revendication 4, dans lequel les cellules solaires (102a-102c) sont réparties le long d'un trajet hélicoïdal le long de la surface de la cavité du concentrateur d'énergie (101).

6. Système photovoltaïque selon la revendication 4, dans lequel les cellules solaires (102a-102c) sont réparties le long d'un trajet hélicoïdal le long de la couche externe du concentrateur d'énergie (101).

7. Système photovoltaïque selon la revendication 1, dans lequel le concentrateur d'énergie (101) comprend au moins une traversée (301, 501-503) pour loger au moins un bouton de commande conçu pour être connecté fonctionnellement à l'électronique des appareils (103) afin de commander les appareils.

8. Système photovoltaïque selon la revendication 7, dans lequel la traversée est métallisée afin de renvoyer par réflexion une lumière incidente provenant du concentrateur d'énergie dans le concentrateur d'énergie (101).

9. Système photovoltaïque selon la revendication 1, comprenant en outre un moyen de stockage d'énergie (303) couplé aux cellules solaires (102), les cellules solaires (102) jouant le rôle de source d'énergie pour les appareils électriques par l'intermédiaire du moyen de stockage d'énergie (303).

10. Système photovoltaïque selon la revendication 9, comprenant en outre un concentrateur d'énergie parent comprenant un moyen de couplage optique qui est conçu pour être connecté optiquement à l'appareil électronique de façon que le concentrateur d'énergie parent joue le rôle de source d'énergie supplémentaire pour le moyen de stockage d'énergie quand il est connecté optiquement à l'appareil électronique.

11. Système photovoltaïque selon la revendication 1, dans lequel le concentrateur d'énergie (101) est formé par au moins une première et une seconde partie de concentrateur d'énergie qui sont connectées optiquement ensemble.

12. Système photovoltaïque selon l'une quelconque des revendications 1 à 11, dans lequel la couche externe (201) est un miroir sélectif de longueur d'onde (203) servant à recueillir une partie des longueurs d'onde du rayonnement électromagnétique entrant, le miroir sélectif de longueur d'onde jouant également le rôle de réflecteur pour le rayonnement électromagnétique entrant.

13. Capteur comprenant un système photovoltaïque (100) selon l'une quelconque des revendications 1 à 12.

14. Appareil électronique (103) comprenant un système photovoltaïque (100) selon l'une quelconque des revendications 1 à 12.
